# EUROPEAN PATENT SPECIFICATION

(11) **EP 0 300 414 B1**
(45) Date of publication and mention of the grant of the patent: **12.10.1994**
(21) Application number: 88111550.5
(22) Date of filing: 18.07.1988
(51) Int. Cl.: H01L 21/31, H01L 21/90

(54) **Method of connecting wirings through connection hole**
Methode zur Verbindung von Leitungen durch Verbindungslöcher
Méthode pour connecter une piste conductrice à travers un trou de connexion

(30) Priority: 20.07.1987 JP 178977/87; 27.07.1987 JP 185384/87
(43) Date of publication of application: 25.01.1989
(73) Proprietor: NIPPON TELEGRAPH AND TELEPHONE CORPORATION, Tokyo (JP)
(72) Inventor: Hashimoto, Chisato, Sagamihara-shi Kanagawa (JP); Machida, Katsuyuki, Isehara-shi Kanagawa (JP); Oikawa, Hideo, Koganei-shi Tokyo (JP)
(74) Representative: Kern, Ralf M., Dipl.-Ing.

(56) References cited:
- EP-A- 0 168 828
- IBM TECHNICAL DISCLOSURE BULLETIN, volume 22, no. 11, April 1980, New York, USA, pages 4883-4885 ; K. CHANG et al. : "Method for controlling via sidewall slope".
- PATENT ABSTRACTS OF JAPAN, volume 9, no. 49 (E-300)(1772), 2nd March 1985 ; & JP-A-59 189 631
- PATENT ABSTRACTS OF JAPAN, volume 7, no. 190 (E-194)(1335), 19th August 1983 ; & JP-A-58 093 237
- J. VAC. SCI. TECHNOL. B, vol. 8, no. 3, pp. 529-532 (1990)
- J. J. APPL. PHYS., Proc. 1989 Intern. Symp. Micro Process Conference, pp. 213-216.

## Description

The present invention relates to a method of connecting electric wirings through connection holes of integrated circuits according to the preamble of claim 1.

As the packing density of LSIs is increased continuously, a demand has arisen for smaller contact holes for connecting the lower electric wiring with an upper electric wiring in integrated circuits. However, in order to prevent dielectric breakdowns the insulating layer for insulating the upper electric wiring from the lower electric wiring cannot be formed thinner than a predetermined thickness which therefore normally must have a thickness of about 0.5 µ or more. Thus the aspect ratio, that is the ratio of the hole depth and the hole diameter of the connection holes has been increased.

In addition, in order to arrange circuit elements with high packing density, multi-layered electric wirings of two or more layers must be formed. In order to form such fine multi-layered electric wirings with high accuracy, the surface of the insulating interlayer has to be flat. Since a variety of circuit elements are formed on the surface of a semiconductor substrate, this normally leads to a undulated surface. Now, if the upper surface of the insulating layer is made flat and connection holes are formed therein, the depths of the connection holes become different in correspondence to the underlying undulations. As a consequence the manufacturing yield and the reliability of the fine multilayered wirings has degraded mainly by the increase of the aspect ratio and the presence of the contact holes having different depths.

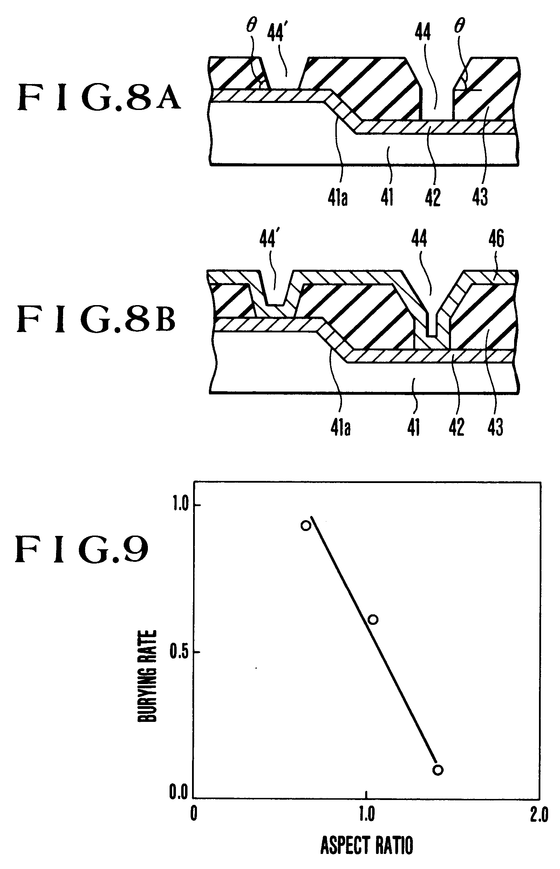

Electric wiring layers are normally formed by depositing a metal such as Al and Mo on the entire surface of a substrate by sputtering whereupon lithographic and etching procedures are performed. However, if the side walls of the connection holes are vertical, the burying rate - that is the ratio of the deposited film thickness within the connection hole versus the deposited film thickness on the flat surface - is abruptly reduced when the aspect ratio as shown in Fig. 9, is increased to more than 1. This means that if the insulating layer cannot be made thin, the metal cannot be deposited sufficiently within the conncetion holes. Thus when the connection hole diameter becomes smaller than a predetermined value, a reliable conncetion to the electric wiring layer cannot be obtained.

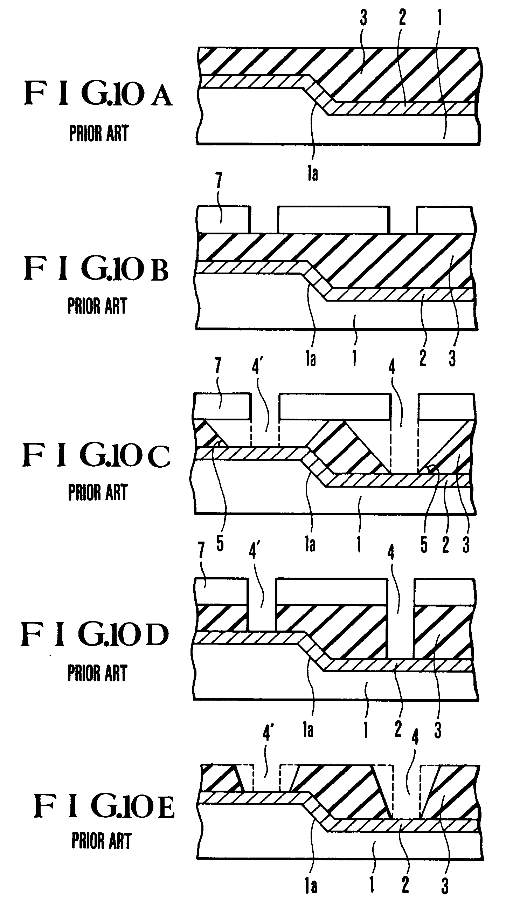

In order to avoid this problem, it is already known to taper the side walls of the connection holes (see f.i.: VSLI Electronics Microstructure Science Vol 1, p 12 and 13 and Vol 2, p 3-12). Thereby the simplest tapering method for opening the connection holes is by wet etching, which will be described with reference to Figs. 10A-C.

According to Fig. 10A, an Al wiring 2 is formed on a semiconductor substrate 1 having a step 1a on its upper surface, whereupon a SiO₂ layer 3 having a flat surface is formed thereon by the known bias sputtering method or the etch-back method. According to Fig. 10B, a resist layer 7 is then deposited by normal lithography in oder to form a contact hole pattern. According to Fig. 10C, through holes 4 and 4′ having different depths are formed by wet etching thereby using a buffer hydrofluoric acid solution and the resist layer 7 as an etching mask. As it is apparent from the shape of the through hole 4, since wet etching is an isotropic etching, the taper angle 5 is about 45°. Thus the pattern conversion difference - that is the difference in size between the resist layer 7 and the SiO₂ layer 3 - becomes about twice as big on an upper surface of the through holes as their depth. Since the shallow through hole 4′ is in contact with the etching solution until the deep through hole 4 is formed, the pattern conversion difference is further increased on the bottom surface of the through hole. Since during wet etching, the etching rate depends on the material a certain amount of overetching must be performed in order to completely form through holes on the entire wafer surface. As a result, the conversion difference is further increased.

Another method of tapering the side walls of connection holes is a method utilizing reactive ion etching (RIE) as dry etching. An example of this method is shown f.i. in the JA-OS 58-93237. In this case, the substrate is processed in the same way as in Figs 10A and B. According to Fig. 10D the SiO₂ layer 3 is then etched by anisotropic etching, whereby connection holes 4 und 4′ are formed having substantially vertical side walls. After removal of the resist layer 7 the RIE-procedure is performed on the entire surface using a gas mixture of C₃F₈ and H₂. If the working conditions are selected such that a polymer is deposited on a flat portions and that etching progresses at the upper end corner portions of the connection holes, only the connection holes are tapered as show in Fig. 10E. Since polymerization and etching are used at the same time, and since the conditions of the polymerization are changed in accordance with the type and the history of an apparatus, the loading effect, the size and the density of a pattern and the like, a rather complex working procedure is required while at the same time the uniformity and the reproducibility of the product tends to be degraded. In addition the side walls of the connection holes cannot be tapered at an arbitrary angle, while differences of the pattern conversion of the connection hole bottom surfaces cannot be eliminated. Even if these difficulties are eliminated, a semiconductor device having a high manufacturing yield and reliability cannot be obtained.

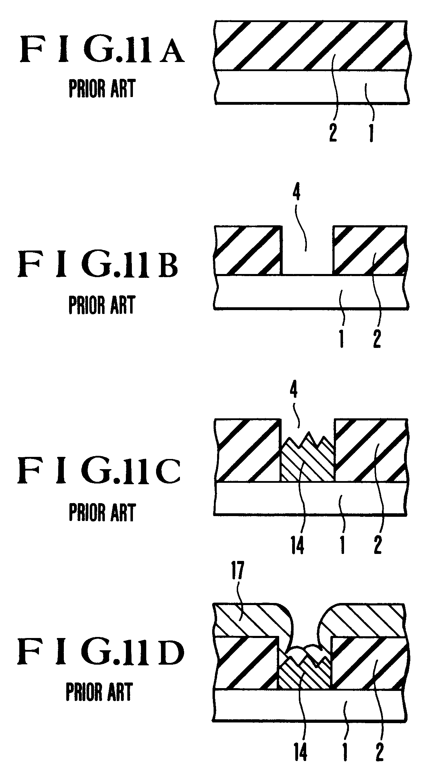

In order to prevent disconnections between electric wiring layers a method of selective growth of tungsten (W) is also known (see f.i. "Selective Low Vapor Deposition of Tungsten" E. K. Broadbent, C. L. Ramiller; Journal of the Electrochemical Society , Vol 131, p. 1427-33). This method utilizes the fact, that in a certain gas atmospheres and within a certain temperature range tungsten can be made to grow only on a conductive layer, but not on an insulating layer. The gas atmosphere is obtained by a gas mixture of WF₆ and H₂, while the temperature is normally about 300°C. The manufacturing steps of this selective growth method used to fill the contact holes will be described with reference to Figs. 11A to D.

According to Fig. 11A, a SiO₂ layer 2 is formed on an Si substrate 1 by a normal CVD or sputtering method. According to Fig. 11B a connection hole 4 is then formed within the SiO₂ layer 2 by lithographic and etching procedures. According to Fig. 11C, tungsten 14 is selectively grown within the connection hole 4. Since selectively grown tungsten 14 has a grain size of several 10⁻⁷ m , undulations of about 10⁻⁷ m are formed on its surface. In addition, the selective growth of tungsten is rather sensitive to the surface conditions of the substrate on which the tungsten is to be grown. In order to prevent electrical short-circuits which occurs when the tungsten within one connection hole overflows and contacts the tungsten selectively grown within an adjecant connection hole, the average grown film thickness of tungsten must be about 80 % or less of the depth of the connection holes. Thereafter, according to Fig. 11D, a metal layer 17 is deposited by a normal sputtering method, which later is formed to a wiring layer by normal lithographic and etching procedure. Thereby the wiring layer 17 must cover sufficiently the tungsten 14 within the connection hole 4. However, since the aspect ratio is increased by recesses formed by the tungsten 14, the wiring layer 17 does not have a sufficient thickness in this areas so that the wiring resistance is largely increased due to this fact. In the worst case, disconnections may occurs.

Therefore, the tungsten selective growth method appears not to be satisfactory in order to form fine multi-layered wirings with a high yield and reliability. In case that connection holes with different depths are present the above problems become even more serious.

An other method for tapering the connection holes within the insulating layer of integrated circuits is known from JA-OS 59-189631 whereby the tapers within of the insulting layer are obtained by high frequency sputtering or ion milling, thereby using an inert gas such as Argon gas.

Considering this state of the art, it is the object of the present invention to provide a method for connecting electric wirings through connection holes in such a way, that while maintaining high manufacturing yields and reliability the burying rate of the connection holes with respect to the upper electric wiring can be increased, while at the same time an increase of the wiring resistance and electric disconnection can be avoided.

Within the framework of the invention this object can be obtained by providing the features, as stated within the characterizing sections of claims 1 and 4.

Further improvements of the invention are obtained by the features stated within the subclaims.

The invention will now be described in detail by refering to the drawings, whereby
- Fig.1A to E: are sectional views showing an embodiment of first method for connecting electric wirings through connection holes according to the present invention;
- Fig. 2: is a schematic view showing a bias ECR etching apparatus which can be used for performing the method according to Fig. 1;
- Fig. 3: is a graph showing the dependency of the sputter etching rate by oxygen ions from the RF power when the bias ECR etching apparatus of Fig. 2 is used;
- Fig. 4: is a graph showing an RF power dependency of a sputter etching rate by normal argon (Ar) ions;
- Fig. 5: is a graph showing an ion incident angle - etching characteristic;
- Fig. 6: is a sectional for explaining selective etching;
- Figs. 7A to 7D and 8A and 8B: are sectional views showing another embodiment of the present invention;
- Fig. 9: is a graph showing an aspect dependency of a normal burying rate; and
- Figs. 10A to 10E and 11A to 11D: are sectional views showing conventional methods of connecting wirings through connection holes.

### Detailed Description of the Preferred Embodiments

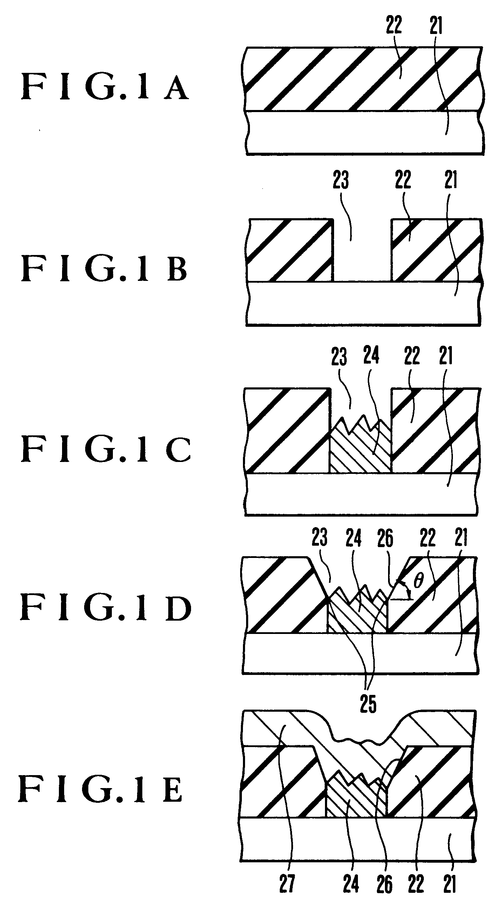

Figs. 1A to 1E show an embodiment of a method of connecting wirings through connection holes according to the present invention. In this embodiment, an Si substrate is used as a first conductive layer, and a second conductive layer is formed on the Si substrate through a connection hole, i.e., a contact hole. First, as shown in Fig. 1A, an SiO₂ layer 22 is formed on an Si substrate 21 serving as a first conductive layer by a normal CVD or sputtering method. Then, as shown in Fig. 1B, a contact hole 23 is formed in the SiO₂ layer 22 by lithography and etching. Thereafter, as shown in Fig. 1C, tungsten 24 is selectively grown as a metal column in the contact hole 23 to be thinner than a depth of the contact hole 23. Note that the above steps are the same as the conventional steps shown in Figs. 11A to 11C.

Then, after the above steps, a taper 26 is formed on a side wall of the contact hole 23 upward from a point 25 contacting an upper surface of the tungsten 24 using selective sputter etching by oxygen ions to be described later, as shown in Fig. 1D. At this time, an angle ϑ of the taper 26 can be controlled to be an arbitrary value within the range of 0° < ϑ < 90°. Therefore, in order not to excessively increase a hole diameter at the upper end of the contact hole 23 with respect to that at its lower end, the angle ϑ of the taper 26 may be increased. Meanwhile, if the aspect ratio of the hole left on the tungsten 24 is so large as to cause disconnection of an upper wiring, the angle ϑ of the taper 26 may be reduced.

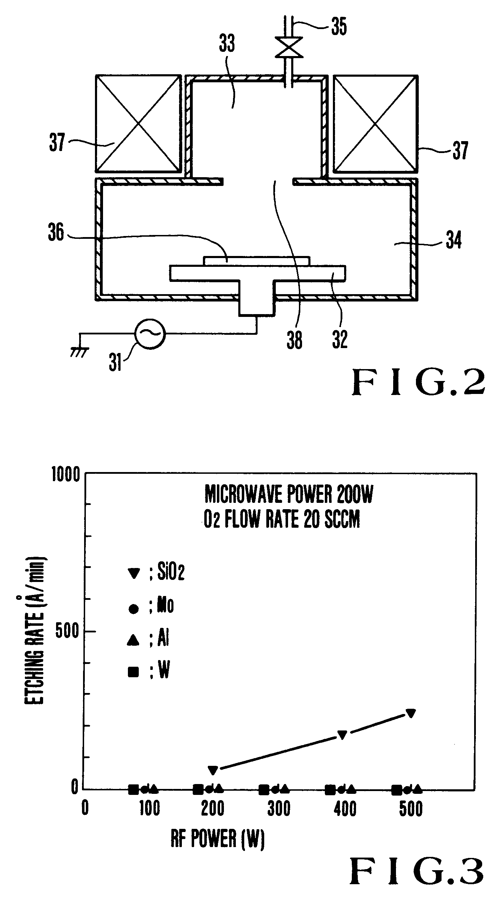

In this case, in order to generate oxygen ions to form the taper 26 shown in Fig. 1D, a bias ECR (ELECTRON CYCLOTRON RESONANCE) etching method is used, and an apparatus therefor will be described below with reference to Fig. 2. In Fig. 2, a substrate electrode 32 connected to an RF bias power source 31 is disposed at a lower central portion in a sample chamber 34, and a sample substrate 36 is disposed thereon. A plasma generating chamber 33 is located above and adjacent to the sample chamber 34, and a window 38 is formed between the plasma generating chamber 33 and the sample chamber 34 so as to oppose the sample substrate 36. A gas supply mechanism 35 is formed above the plasma generating chamber 33 to supply an etching gas such as O₂ gas or Ar gas. A magnet coil 37 is disposed around the plasma generating chamber 33 to efficiently transport ions generated in the plasma generating chamber 33 by a magnetic field to the sample chamber 34. In order to generate ions in the plasma generating chamber 33, a microwave electron cyclotron resonance method is used. According to such a bias ECR etching apparatus, an oxygen plasma can be generated at a high vacuum pressure of 1,33 * 10⁻²-1,33*10⁻³Pa. Therefore, a generation efficiency of oxygen ions is high and oxygen ions are further accelerated by applying an RF bias voltage to the substrate electrode 32. As a result, high-speed sputter etching by oxygen ions can be performed on the sample substrate 36.

A difference between etching characteristics of an insulating material and a conductive material obtained by oxygen ions when the bias ECR etching apparatus is used will be described below. Fig. 3 shows RF power dependencies of etching rates of SiO₂, Mo, W, and Al obtained by oxygen ions when the bias ECR etching apparatus in Fig. 2 is used. In Fig. 3, the RF power is plotted along the abscissa, and the etching rate is plotted along the ordinate. As is apparent from Fig. 3, as the RF power is increased, the etching rate of SiO₂ is increased, but Mo, W, and Al are not etched. This is because although a metal surface is oxidized by oxygen ions, the surface of the formed metal oxide is oxygen. Therefore the metal is not etched unless the oxygen is sputter-etched by oxygen ions again. That is, the metal is not etched because the metal is immediately oxidized even if the oxygen is etched by sputtering.

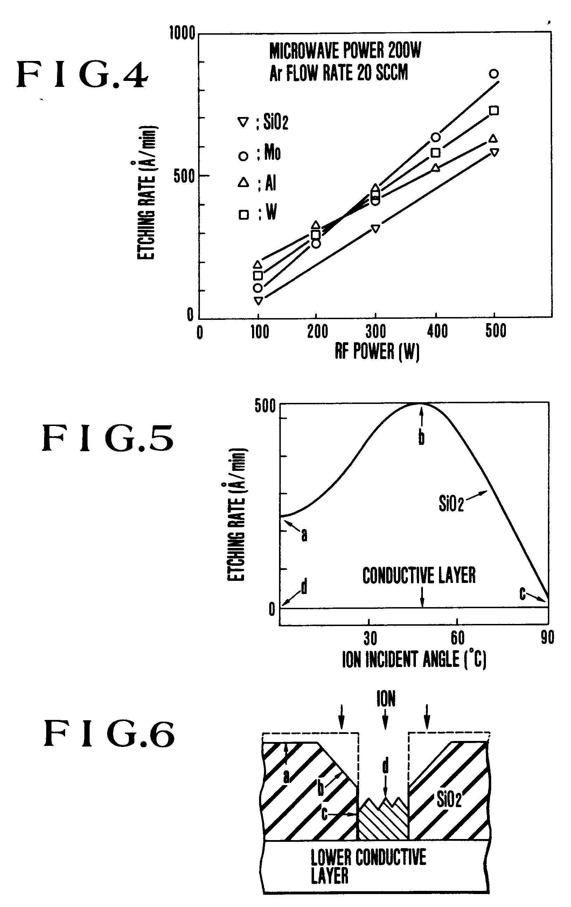

Meanwhile, Ar ions used in normal sputter etching do not form a compound with a metal. Therefore, as shown in Fig. 4, although etching rates are slightly different, any of SiO₂, Mo, W, and Al is sputter-etched.

The reason why the tapered shape as shown in Fig. 1D is obtained by sputter etching using an O₂ gas will be described. First, the side wall of the contact hole 23 in Fig. 1C is tapered on the basis of a well-known incident angle dependency of a sputtering rate. That is, since etching ions are incident vertically on the sample substrate 36 in Fig. 2, the side wall of the contact hole 23 in Fig. 1C is not etched when the angle of the taper 26 in Fig. 1D is 90°.

However, an electric field is concentrated to an upper end corner portion of the contact hole 23. As a result, SiO₂ at the corner portion is sputter-etched to form a small tapered portion. When this small tapered portion is formed, formation of the taper 26 begins using the small tapered portion as a core.

A relationship between an ion incident angle and an etching rate with respect to the SiO₂ layer 22 is well shown in Fig. 5. In Fig. 5, when the incident angle is 0°, the SiO₂ layer 22 is ion-etched at an etching rate indicated by arrow a. When the incident angle is 0°, ions are incident on a flat portion of the SiO₂ layer 22. Therefore, the flat portion is etched at a certain rate. When the taper is formed at the upper end corner portion of the contact hole 23, the ion incident angle at the portion is gradually increased, and the etching rate is increased. As is apparent from Fig. 5, the etching rate is highest at an incident angle of about 45°. Therefore, when ion etching is performed for a predetermined time, the SiO₂ layer 22 is etched from a state indicated by broken lines to a state indicated by solid lines in Fig. 6. Since the ion incident angle on the side wall of the contact hole 23 is 90°, the etching rate is reduced to be almost 0 as is shown at a portion indicated by c in Fig. 5, i.e., the side wall is almost not etched. In addition, the metal portion (tungsten 24) is almost not etched as is apparent from a portion d of the characteristic shown in Fig. 5. As a result, in Fig. 6, the tungsten 24 is almost not or not etched at all.

The taper 26 is formed from the point 25 at which the side wall of the contact hole 23 is in contact with the tungsten 24. As described above, the sputtering rate on the inclined surface (an angle of the taper 26 is larger than 0° and smaller than 90°) is higher than that on the flat surface (the angle of the taper 26 is 0°). In other words, since the etching rate is higher on the inclined surface, the angle ϑ of the taper 26 is reduced while a film thickness of the SiO₂ layer 22 is not reduced very much. At this time, it should be noted that a position of the point 25 of the taper 26 is almost not changed. Meanwhile, although the taper is formed when sputter etching is performed by Ar ions, the tungsten 24 in Fig. 1D is undesirably etched at the same time (Fig. 4). However, as in the above embodiment, when sputtering is performed by oxygen ions the tungsten 24 is not etched.

In this manner, when the taper 26 as shown in Fig. 1D is formed on the side wall of the contact hole 23 by selective sputter etching using oxygen ions, the tungsten 24 is not etched. Therefore, a position of the point 25 is not changed, and the angle ϑ of the taper 26 is changed from 90° to 0° with a slight film thickness decrease of the SiO₂ layer 22 on the flat surface. After the desired angle ϑ of the taper 26 is obtained in this manner, tungsten oxide formed on the surface of the tungsten 24 is removed by a normal reverse sputtering method or the like. At this time, the tungsten oxide can be easily removed because its film thickness is at most 200 Å. Then, as shown in Fig. 1E, the metal layer is deposited by a normal sputtering method or the like, and then the wiring layer 27 is formed as a second conductive layer by normal lithography and etching. As a result, the wiring layer 27 is conductively connected on the Si substrate 21 through the contact hole 23 including the tungsten 24. In this case, unlike in the conventional methods, since the taper 26 is formed on the side wall of the contact hole 23, the wiring layer 27 can have a sufficient film thickness in the contact hole 23 even if the aspect ratio is high. For this reason, an increase in electrical resistance or disconnection in the contact hole 23 of the wiring layer 27 can be prevented. Therefore, according to the present invention, a semiconductor apparatus having fine connection holes with high manufacturing yield and reliability can be obtained.

Note that in the above embodiment, tungsten is used as a metal column in a connection hole, but another metal such as Mo or Al may be used. In addition, a selective growth method is used as a deposition method of the metal, but another method such as a combination of a normal CVD method and etch-back may be used.

Furthermore, the bias ECR etching apparatus is used as an etching apparatus for forming a taper. However, a condition that an insulating film is etched by oxygen ions need only be satisfied. Therefore, it is a matter of course that an etching apparatus of another system not departing from this concept may be used.

In the above embodiment, two conductive layers are formed. However, the present invention is not limited to the above embodiment, and three or more conductive layers may be formed. When a connection hole in which a metal column need not be buried because its depth is small is present together with other connection holes, the metal column need not be buried in this connection hole but only a taper may be formed in the connection hole by etching using oxygen ions. That is, a connection hole not according to the present invention or a connection hole partially according to the present invention may be present together with the connection hole according to the present invention without posing any problem.

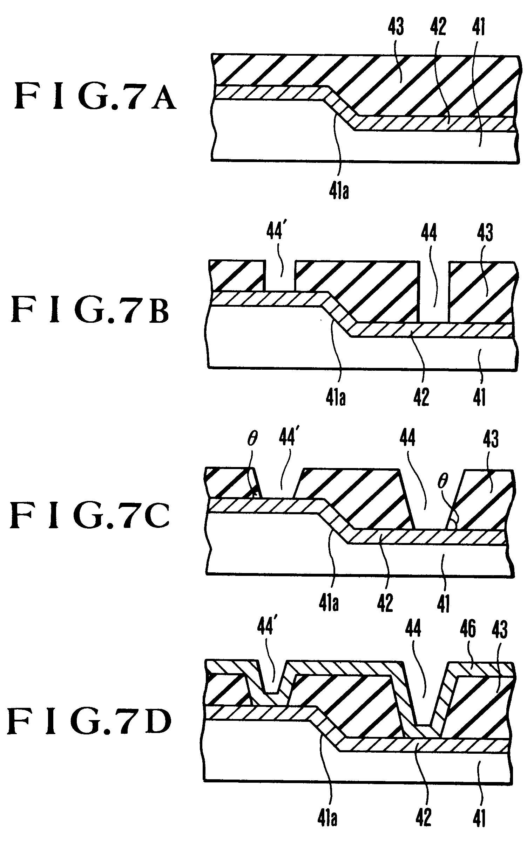

Figs. 7A to 7D show another embodiment of the present invention in which the metal column described above is not buried. First, as shown in Fig. 7A, an Al wiring 42 is formed as a first conductive layer on a semiconductor substrate 41 having a step 41a on its surface, and an SiO₂ layer 43 is formed thereon as an insulating layer. Then, as shown in Fig. 7B, through holes 44 and 44′ are formed as connection holes in the SiO₂ layer 43 by lithography and etching. Subsequently, as in the above embodiment, tapers are formed on side walls of the through holes 44 and 44′ by selective sputter-etching using oxygen ions, respectively, as shown in Fig. 7C. In this case, the tapers are formed as in the above embodiment. That is, each of the contact holes 44 and 44′ is gradually etched from its upper end corner portion to form a predetermined taper. A taper angle ϑ of the taper can be controlled to be an arbitrary value within the range of 0° < ϑ < 90°. Therefore, in order not to excessively increase a hole diameter at the upper end of each of the through holes 44 and 44′ with respect to that at its lower end, the taper angle ϑ may be increased. Meanwhile, if an aspect ratio of the through holes 44 and 44′ is large to cause disconnection of the upper wiring, the taper angle ϑ may be reduced.

In this embodiment, the taper is formed from a point of the contact hole 44 contacting the first conductive layer 42. Therefore, the diameter of the contact hole 44′ is slightly larger than that at the start of formation. As an apparatus for forming the taper, the bias ECR etching apparatus or the other known etching apparatuses are used. Then, as shown in Fig. 7D, a metal layer is deposited by a normal sputtering method or the like, and a wiring layer 46 as a second conductive layer is formed by normal lithography and etching. In this case, since the sufficient tapers are formed on the side walls of the through holes 44 and 44′ , the wiring layer 46 can have a sufficient film thickness in the through holes 44 and 44′ even if the aspect ratio is high. Therefore, an increase in electrical resistance or disconnection in the through holes 44 and 44′ of the wiring layer 46 is prevented. In this manner, a semiconductor apparatus with a high manufacturing yield and reliability and having connection holes with a high aspect ratio can be obtained without considering an increase in area caused by a pattern conversion difference.

Figs. 8A and 8B show a modification of the embodiment in Figs. 7A to 7D, corresponding to Figs. 7C and 7D. In this case, a taper is formed from a portion of a contact hole 44′ contacting a first conductive layer 42. Therefore, in the contact hole 44, the taper is formed upward from a middle portion of a side wall.

## Claims

1. Method for connecting electric wirings through connection holes of integrated circuits, comprising the following steps:
- forming a first metal conductive layer for a first electric wiring (42) on a substrate (41)
- forming an insulating layer (43) on this substrate (41)
- forming connection holes (44, 44′) within this insulating layer (43) said holes being provided with tapered side walls and
- forming a second metal conductive layer for a second electric wiring (46) on the insulating layer (43), which electricly connects through the tapered connection holes (44, 44′) to the first electric wiring (42) on the substrate (41)
**characterized** in that the tapering of the the side walls of the connection holes (44, 44′) is obtained after formation of the connection holes by using a selective sputter etching technique with oxygen ions, wherein the oxygen ions react with the material of the first electric wiring layer to form a metal oxide thereon, thus leading to slower etching of this wiring layer with respect to the insulating layer (43), and the tapering of the side walls of the connection holes (44, 44′).

2. Method according to claim 1, characterized in that following the forming of the connection holes (44, 44′) but before the tapering of the side walls is done metal columns are formed within these connection holes (44, 44′).

3. Method according to claim 1 or 2, characterized in that the selective sputter etching technique with oxygen ions is performed such that only the upper parts of the connection holes (44) within the insulating layer (43) are tapered.

4. Method for connecting electric wirings through connection holes of integrated circuits, comprising the following steps:
- using a substrate surface as a first electric wiring (21)
- forming an insulating layer (22) on this substrate surface (21)
- forming connection holes (23) within this insulating layer (22) said holes being provided with tapered side walls (26) and
- forming a metal conductive layer for a second electric wiring (27) on the insulating layer (22), which electricly connects through the tapered connection holes (23) to the first electric wiring (21)
**characterized** in that following the forming of the connection holes (23) but before the tapering of the side walls (26) is done metal columns (24) are formed within these connection holes (23) and in that the tapering of the the side walls (26) of the connection holes (23) is obtained by using a selective sputter etching technique with oxygen-ions, wherein the oxygen ions react with the metal columns (24) to form a metal oxide thereon, thus leading to slower etching of these metal columns (24) with respect to the insulating layer (22), and the tapering of the side walls (26) of the connection holes (23).

## Patentansprüche

1. Methode zum Verbinden elektrischer Leitungen durch Verbindungslöcher in integrierten Schaltungen, enthaltend die folgenden Schritte:
- Ausbilden einer ersten elektrisch leitenden Schicht für erste elektrische Leitungen (42) auf einem Substrat (41)
- Ausbilden einer Isolierschicht (43) auf diesem Substrat (41)
- Ausbilden von Verbindungslöchern (44, 44′) innerhalb dieser Isolierschicht (43), wobei diese Löcher konisch schräg zulaufende Seitenwände aufweisen, und
- Ausbilden einer zweiten, metallischen, leitenden Schicht für zweite elektrische Leitungen (46) auf der Isolierschicht (43), die durch die konischen Verbindungslöcher (44, 44′) mit den ersten Leitungen (42) auf dem Substrat elektrisch verbunden sind,
dadurch gekennzeichnet, daß die konische Schräge der Seitenwände der Verbindungslöcher (44, 44′) nach dem Ausbilden der Verbindungslöcher durch Einsatz einer selektiven Sputter-Ätztechnik mit Sauerstoffionen erhalten wird, wobei die Sauerstoffionen mit dem Material der ersten elektrischen Leitungsschicht reagieren, um darauf eine Metalloxidschicht auszubilden, und damit zu einem langsameren Ätzen dieser Leitungsschicht gegenüber der Isolierschicht (43) und zum konischen Schrägen der Seitenwände der Verbindungslöcher (44, 44′) führen.

2. Methode gemäß Anspruch 1, dadurch gekennzeichnet, daß nach dem Ausbilden der Verbindungslöcher (44, 44′), jedoch vor dem konischen Schrägen der Seitenwände innerhalb dieser Verbindungslöcher (44, 44′) Metallsäulen gebildet werden.

3. Methode gemäß Anspruch 1 oder 2, dadurch gekennzeichnet, daß die selektive Sputter-Ätztechnik mit Sauerstoffionen so ausgeführt wird, daß nur die oberen Teile der Verbindungslöcher (44) innerhalb der Isolierschicht (43) konisch geschrägt werden.

4. Methode zum Verbinden elektrischer Leitungen durch Verbindungslöcher in integrierten Schaltungen, enthaltend die folgenden Schritte:
- Benutzen einer Substratoberfläche als erste elektrische Leitungen (21)
- Ausbilden einer Isolierschicht (22) auf dieser Substratoberfläche (21)
- Ausbilden von Verbindungslöchern (23) innerhalb dieser Isolierschicht (22), wobei diese Löcher konisch schräg zulaufende Seitenwände (26) aufweisen, und
- Ausbilden einer metallischen, leitenden Schicht für zweite elektrische Leitungen (27) auf der Isolierschicht (22), die durch die konischen Verbindungslöcher (23) mit den ersten elektrischen Leitungen (21) elektrisch verbunden sind,
dadurch gekennzeichnet, daß nach dem Ausbilden der Verbindungslöcher (23), jedoch vor dem konischen Schrägen der Seitenwände (26), Metallsäulen (24) innerhalb dieser Verbindungslöcher (23) gebildet werden, und daß das konische Schrägen der Seitenwände (26) der Verbindungslöcher (23) durch Einsatz einer selektiven Sputter-Ätztechnik mit Sauerstoffionen erhalten wird, wobei die Sauerstoffionen mit den Metallsäulen (24) reagieren, um darauf ein Metalloxid auszubilden, und damit zu einem langsameren Ätzen dieser Metallsäulen (24) gegenüber der Isolierschicht (22) und zum konischen Schrägen der Seitenwände (26) der Verbindungslöcher (23) führen.

## Revendications

1. Procédé pour connecter des câblages électriques à travers des trous de connexion dans des circuits intégrés, comprenant les étapes suivantes :
- on forme une première couche conductrice métallique pour un premier câblage électrique (42) sur un substrat (41)
- on forme une couche isolante (43) sur ce substrat (41)
- on forme des trous de connexions (44, 44′) à l'intérieur de cette couche isolante (43), lesdits trous étant dotés de parois latérales inclinées, et
- on forme une seconde couche conductrice métallique pour un second câblage électrique (46) sur la couche isolante (43), qui connecte électriquement à travers les trous de connexion inclinés (44, 44′) vers le premier câblage électrique (42) sur le substrat (41)
caractérisé en ce que l'inclinaison des parois latérales des trous de connexion (44, 44′) est obtenue après formation des trous de connexion en utilisant une technique d'attaque par pulvérisation sélective avec des ions d'oxygène, dans laquelle les ions d'oxygène réagissent avec le matériau de la première couche de câblage électrique afin de former un oxyde métallique sur celle-ci, menant ainsi à une attaque plus lente de cette couche de câblage par rapport à la couche isolante (43), et à une inclinaison des parois latérales des trous de connexion (44, 44′).

2. Procédé selon la revendication 1, caractérisé en ce qu'à la suite de la formation des trous de connexion (44, 44′), mais avant de procéder à l'inclinaison des parois latérales, on forme des colonnes à l'intérieur de ces trous de connexion (44, 44′).

3. Procédé selon l'une ou l'autre des revendications 1 et 2, caractérisé en ce que la technique d'attaque par pulvérisation sélective avec des ions d'oxygène est effectuée de telle manière que seules les parties supérieures des trous de connexion (44) à l'intérieur de la couche isolante (43) sont inclinées.

4. Procédé pour connecter des câbles électriques à travers des trous de connexion de circuits intégrés, comprenant les étapes suivantes :
- on utilise en tant que premier câblage électrique (21) une surface d'un substrat
- on forme une couche isolante (22) sur cette surface de substrat (21)
- on forme des trous de connexion (23) dans cette couche isolante (22), lesdits trous étant pourvus de parois latérales inclinées (26), et
- on forme une couche conductrice métallique pour un second câblage électrique (27) sur la couche isolante (22), qui connecte électriquement à travers les trous de connexion inclinée (23) vers le premier câblage électrique (21),
caractérisé en ce qu'à la suite de la formation des trous de connexion (23) mais avant de procéder à l'inclinaison des parois latérales (26), on forme des colonnes (24) à l'intérieur de ces trous de connexion (23), et en ce que l'inclinaison des parois latérales (26) des trous de connexion (23) est obtenue en utilisant une technique d'attaque par pulvérisation sélective avec des ions d'oxygène, dans laquelle les ions d'oxygène réagissent avec les colonnes métalliques (24) afin de former un oxyde métallique sur celle-ci, menant ainsi à une attaque plus lente de ces colonnes métalliques (24) par rapport à la couche isolante (22), et à l'inclinaison des parois latérales (26) des trous de connexion (23).
